# EUROPÄISCHE PATENTSCHRIFT

(11) **EP 4 241 092 B1**
(45) Veröffentlichungstag und Bekanntmachung des Hinweises auf die Patenterteilung: **24.07.2024**
(21) Anmeldenummer: 21806953.2
(22) Anmeldetag: 08.11.2021
(51) Int. Cl.: G01R 15/06, G01R 15/04

(54) **SPANNUNGSSENSOR MIT OHMSCH-KAPAZITIVEM SPANNUNGSTEILER**
VOLTAGE SENSOR WITH OHMIC CAPACITIVE VOLTAGE DIVIDER
CAPTEUR DE TENSION À DIVISEUR DE TENSION CAPACITIF OHMIQUE

(30) Priorität: 09.11.2020 AT 509602020
(43) Veröffentlichungstag der Anmeldung: 13.09.2023
(73) Patentinhaber: Greenwood-Power GmbH, 2471 Rohrau (AT)
(72) Erfinder: JUSCHICZ, Norbert, 2404 Petronell-Carnuntum (AT); BACHER, Willibald, 2404 Petronell-Carnuntum (AT)
(74) Vertreter: Puchberger & Partner Patentanwälte
(86) Internationale Anmeldenummer: PCT/AT2021/060414
(87) Internationale Veröffentlichungsnummer: WO 2022/094645

(56) Entgegenhaltungen:
- HALLSTROM JARI ET AL: "Performance of a Wideband 200-kV HVDC Reference Divider Module", IEEE TRANSACTIONS ON INSTRUMENTATION AND MEASUREMENT, IEEE, USA, vol. 63, no. 9, 1 September 2014 (2014-09-01), pages 2264 - 2270, XP011555642, ISSN: 0018-9456, [retrieved on 20140807], DOI: 10.1109/TIM.2014.2304857

## Beschreibung

Die Erfindung betrifft einen Spannungssensor zur Messung einer Hochspannung mit einem ohmsch-kapazitiven Spannungsteiler gemäß dem Oberbegriff des unabhängigen Patentanspruchs.

Spannungssensoren werden in Schaltanlagen von Stromnetzen bei der Messung der elektrischen Spannung eingesetzt. Aus dem Stand der Technik sind Spannungssensoren mit ohmschen Spannungsteilern bekannt. Diese arbeiten mit zumindest zwei in Serie geschalteten elektrischen Widerständen im Niederspannungs-Sekundärkreis, wodurch die Spannung des zu messenden Hochspannungs-Primärkreises entsprechend dem Verhältnis der Widerstände aufgeteilt wird. Rein ohmsche Spannungsteiler haben jedoch den Nachteil, dass beispielsweise vom Verbindungskabel oder von den weiteren Bauelementen stammende Streukapazitäten und/oder parasitische Kapazitäten einen großen Einfluss auf den tatsächlichen Messwert und somit auf die Messgenauigkeit haben.

Zur Messung von hohen Wechselspannungen sind ohmsch-kapazitive Spannungsteiler bekannt, welche im Sekundärkreis wenigstens einen elektrischen Widerstand und einen parallel dazu geschalteten elektrischen Kondensator mit einer vorab definierten Kapazität aufweisen.

Beispielsweise offenbaren Hallstrom Jari et al. in IEEE Transactions on Instrumentation and Measurement, Bd. 63, Nr. 9, 1. September 2014, S. 2264-2270 einen Hochspannungsteiler mit einem High-Voltage-Arm und einem Low-Voltage-Arm.

Ohmsch-kapazitive Spannungsteiler werden regelmäßig in Mittel- und Hochspannungsschaltanlagen von über 1 kV eingesetzt. Sie teilen die hohe Wechselspannung der Primärseite zur Messung in eine äquivalente niedrigere Wechselspannung auf der Sekundärseite. Der ohmsch-kapazitive Spannungsteiler umfasst eine erste Widerstand-Kondensator-Parallelschaltung und eine zweite Widerstand-Kondensator-Parallelschaltung, wobei die Widerstand-Kondensator-Parallelschaltungen elektrisch in Serie angeordnet sind. Der elektrische Widerstand der ersten Parallelschaltung ist wesentlich höher als jener der zweiten Parallelschaltung, sodass der Spannungsabfall an der zweiten Parallelschaltung in einer niedrigen Relation zur Hochspannung steht. Beide Parallelschaltungen sind aufeinander abgeglichen und bilden transiente Spannungssignale von der Hochspannungsseite auf die Niederspannungsseite ab.

Ein Problem derartiger bekannter Spannungssensoren mit einem ohmsch-kapazitiven Spannungsteiler besteht darin, dass die RC-Teiler der Sekundärseite nicht oder nur schwer kalibrierbar sind. Um bei der Messung von hohen Wechselspannungen die erforderte Genauigkeit zu erreichen, sollte der Sekundärkreis des Spannungssensors jedoch ein Abbild des zu messenden Primärkreises sein, d.h. der komplexe Widerstand des Sekundärkreises sollte an den komplexen Widerstand des Primärkreises angepasst sein. Dies ist insbesondere bei der Bestimmung von Harmonischen der Netzfrequenz wünschenswert, da hier Frequenzen im Bereich von 1 kHz oder höher untersucht werden müssen. Der komplexe Widerstand des Primärkreises wird jedoch von Fertigungsungenauigkeiten bei der Geometrie und dem Widerstandswert des ohmschen Hochspannungswiderstands beeinflusst, sodass der erforderliche elektrische Widerstand und die erforderliche Kapazität nicht im Vorhinein genau bestimmt werden können. Die eingesetzten Komponenten der Primärseite weisen eine Ungenauigkeit von bis zu +/-20% auf. Auch der komplexe Widerstand der Sekundärseite ist von Kabellängen und Eingangsimpedanzen des Messgeräts abhängig.

Die Aufgabe der Erfindung besteht unter anderem darin, diese Probleme bekannter Spannungssensoren zu lösen und einen Spannungssensor mit einem ohmsch-kapazitiven Spannungsteiler bereitzustellen, der sich einfach an das Messobjekt anpassen lässt und somit insbesondere bei hohen Frequenzen eine höhere Messgenauigkeit als herkömmliche Spannungssensoren liefert.

Diese und andere Aufgaben werden durch die Merkmale des kennzeichnenden Teils des Anspruchs 1 gelöst.

Erfindungsgemäß ist ein Spannungssensor zur Messung einer Hochspannung vorgesehen, der eine Hochspannungs-Primärseite und eine Niederspannungs-Sekundärseite aufweist. Zur Erzeugung der Niederspannung ist ein ohmsch-kapazitiven Spannungsteiler mit einer ersten Widerstand-Kondensator-Parallelschaltung und einer zweiten Widerstand-Kondensator-Parallelschaltung vorgesehen, wobei die Widerstand-Kondensator-Parallelschaltungen elektrisch in Serie angeordnet sind. Dadurch steht der Spannungsabfall an der zweiten Widerstand-Kondensator-Parallelschaltung in bekannter Weise in einer Relation zur Hochspannung. Durch passende Wahl der Widerstands- und Kapazitätswerte kann eine gewünschte Relation eingestellt werden.

Erfindungsgemäß ist vorgesehen, dass zum elektrischen Abgleich der Sekundärseite parallel zur zweiten Widerstand-Kondensator-Parallelschaltung ein Widerstand-Kondensator-Netzwerk mit einer Vielzahl an parallel geschalteten und selektiv deaktivierbaren Widerständen und Kondensatoren vorgesehen ist. Die Widerstände und Kondensatoren können unterschiedliche nominale Werte aufweisen, sodass durch Deaktivierung bestimmter Bauelemente in Summe ein gewünschter Widerstand und eine gewünschte Kapazität entstehen. Beim Einbau und auch beim Betrieb des Spannungssensors kann somit durch Messung und selektives Deaktivieren von Widerständen und Kondensatoren der komplexe Widerstand der Sekundärseite an jenen der Primärseite angepasst werden. Dadurch kann auch eine Anpassung bereits im Werk ermöglicht werden, und eine Anpassung vor Ort erübrigt sich. Der erfindungsgemäße Spannungssensor zeichnet sich durch eine außerordentliche Zuverlässigkeit der Trennung und leicht zu realisierender Automatisierung aus.

Erfindungsgemäß ist vorgesehen, dass das Widerstands-Kondensator-Netzwerk eine Vielzahl an parallelen Widerständen umfasst, wobei in Serie zu jedem Widerstand jeweils eine Schmelzsicherung angeordnet ist. Erfindungsgemäß kann auch vorgesehen sein, dass das Widerstands-Kondensator-Netzwerk eine Vielzahl an parallelen Kondensatoren umfasst, wobei in Serie zu jedem Kondensator jeweils eine Schmelzsicherung angeordnet ist.

Statt den Schmelzsicherungen wäre es zwar denkbar, aber nicht erfindungsgemäss, auch andere Trennelemente einzusetzen.

Ein Vorteil der Schmelzsicherungen besteht jedoch darin, dass eine robuste und dauerhafte Deaktivierung der jeweiligen Bauelemente ermöglicht wird, ohne dass es erforderlich ist, auf das Innere des Spannungssensors selbst zugreifen zu müssen. Ein weiterer Vorteil ist, dass der Spannungssensor elektrisch in einem vollautomatisierten Prozess abgeglichen werden kann.

Erfindungsgemäß kann vorgesehen sein, dass die Schmelzsicherungen über separate elektrische Anschlussleitungen verfügen. Die Anschlussleitungen können einzeln nach außen an ein elektrisches Steckpanel geführt sein. Dies hat den Vorteil, dass die Deaktivierung der gewählten Bauelemente vor Ort durch Anlegen einer ausreichend hohen Gleichspannung an die Steckverbindungen des Steckpanels ermöglicht wird, ohne dass der Spannungssensor ausgebaut und geöffnet werden muss. Das Steckpanel kann vorzugsweise an einer Außenfläche des Spannungssensors angeordnet sein.

Erfindungsgemäß kann der Spannungssensor zur Messung einer Hochspannung von über 1 kV, gegebenenfalls über 20 kV, insbesondere bis zu einer Spannung 110 kV ausgelegt sein. Es kann sich dabei vorzugsweise um Wechselspannung mit einer Frequenz im Bereich von 50 Hz handeln.

Die Erfindung betrifft ferner eine Messanordnung umfassend einen erfindungsgemäßen Spannungssensor, wobei die Sekundärseite der über eine geschirmte und mit Masse verbundene Messleitung mit einem Messverstärker verbunden ist.

Weitere erfindungsgemäße Merkmale ergeben sich aus der Beschreibung des Ausführungsbeispiels, der Figur und den nachfolgenden Patentansprüchen. Im Folgenden wird die Erfindung an Hand eines nicht ausschließlichen Ausführungsbeispiels näher erläutert.

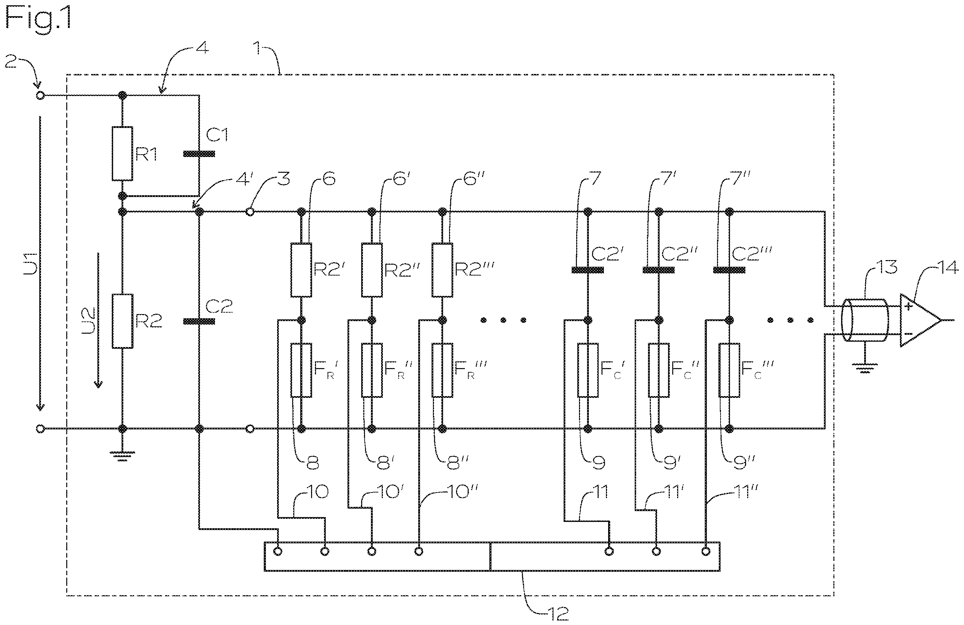

Fig. 1 zeigt ein Ausführungsbeispiel eines erfindungsgemäßen Spannungssensors in einer erfindungsgemäßen Messanordnung.

Fig. 1 zeigt ein exemplarisches Ausführungsbeispiel eines erfindungsgemäßen Spannungssensors 1 in einer erfindungsgemäßen Messanordnung. Der Spannungssensor 1 ist ein einem Gehäuse angeordnet und hat eine Hochspannungs-Primärseite 2 mit Anschlussklemmen zum Anschluss der zu messenden Hochspannung U1. Dabei handelt es sich um eine Wechselspannung mit Netzfrequenz.

Aus der Hochspannung U1 wird im Spannungssensor 1 über einen ohmsch-kapazitiven Spannungsteiler eine Niederspannung U2 generiert, die in einer direkten Relation zur Hochspannung U1 steht. Durch Messung der Niederspannung U2 kann die Hochspannung U1 berechnet werden. Der ohmsch-kapazitive Spannungsteiler umfasst eine erste Widerstand-Kondensator-Parallelschaltung 4 mit dem Widerstand R1 und dem Kondensator C1 und eine zweite Widerstand-Kondensator-Parallelschaltung 4` mit dem Widerstand R2 und dem Kondensator C2. Die Widerstand-Kondensator-Parallelschaltungen 4, 4' sind in Serie angeordnet. Die Niederspannung U2 fällt an der zweiten Widerstand-Kondensator-Parallelschaltung 4' ab und wird an der Niederspannungs-Sekundärseite 3 des Spannungssensors 1 zur Verfügung gestellt. Es kann sich dabei um eine genormte Spannungshöhe handeln, um eine einfache Messung mit genormten Messgeräten zu ermöglichen. In einem Ausführungsbeispiel der Erfindung kann die Nennfrequenz 50 Hz betragen. Die Werte der Widerstände und Kondensatoren können dabei wie folgt sein: R1 = 200 MΩ, R2 = 32,5 kΩ, C1 = 2000 pF, C2 = 0,325 pF. Dabei gilt frequenzunabhängig dass R1 / R2 = C2 / C1 = U1 / U2.

Zum Abgleich der Sekundärseite 3 ist parallel zur zweiten Widerstand-Kondensator-Parallelschaltung 4' ein Widerstand-Kondensator-Netzwerk 5 mit einer Vielzahl an parallel geschalteten und selektiv deaktivierbaren Widerständen 6, 6', 6" und Kondensatoren 7, 7', 7" vorgesehen. Die Werte der Widerstände und Kondensatoren sind unterschiedlich, um einen möglichsten großen Widerstands- und Kapazitätsbereich abdecken zu können. Vorzugsweise sind zumindest drei Widerstände R2', R2", R2‴ und zumindest drei Kondensatoren C2`, C2", C2‴ vorgesehen. In einem Ausführungsbeispiel der Erfindung können die Widerstandswerte wie folgt sein: R2' = 56 kΩ, R2" = 110 kΩ, R2‴ = 220 kΩ. Die Werte der Kondensatoren können dabei wie folgt sein: C2' = 1 nF, C2" = 560 pF, C2‴ = 220 pF. Es können bis zu 15 Widerstände und bis zu 10 Kondensatoren vorgesehen sein.

In Serie zu jedem der drei Widerstände 6, 6', 6" sind Schmelzsicherungen 8, 8', 8" angeordnet. In gleicher Weise sind in Serie zu jedem der drei Kondensatoren 7, 7', 7" Schmelzsicherungen 9, 9', 9" angeordnet. Im dargestellten Zustand beeinflussen diese elektrischen Bauelemente den komplexen Widerstand der Sekundärseite 3 des Spannungssensors.

Zur Deaktivierung, also Durchbrennen, der Schmelzsicherungen 8, 8', 8", 9, 9', 9" verfügen diese jeweils über eine separate elektrische Anschlussleitung 10, 10', 10", 11, 11', 11". Über diese Anschlussleitungen kann jede einzelne Schmelzsicherung mit einem hohen Gleichstrom beaufschlagt werden, sodass sie durchbrennt. Bauelemente, deren Schmelzsicherung durchgebrannt ist, beeinflussen den komplexen Widerstand der Sekundärseite 3 des Spannungssensors nicht mehr, sodass durch selektive Deaktivierung einzelner Widerstände 6, 6', 6" und Kondensatoren 7, 7', 7" der komplexe Widerstand der Sekundärseite 3 in einem weiten Bereich eingestellt werden kann.

Um eine einfache Deaktivierung der Bauteile R2', R2", R2‴ sowie C2', C2", C2‴ zu ermöglichen, sind die jeweiligen Anschlussleitungen an ein gemeinsames elektrisches Steckpanel 12 geführt. Dieses ist zwar ein Teil des Spannungssensors 1, befindet sich jedoch leicht zugänglich an dessen Außenfläche, sodass bei der Montage des Spannungssensors 1 vor Ort in einfacher Weise eine Anpassung durch Durchbrennen einzelner Schmelzsicherungen erfolgen kann.

Ferner ist in Figur 1 dargestellt dass die Sekundärseite 3 des Spannungssensors 1 über eine geschirmte Messleitung 13 mit einem Messverstärker 14 verbunden ist.

Die Erfindung beschränkt sich nicht auf das beschriebene Ausführungsbeispiel sondern umfasst sämtliche Vorrichtungen im Rahmen der nachfolgenden Patentansprüche.

## Patentansprüche

1. Spannungssensor (1) zur Messung einer Hochspannung, umfassend
a. eine Hochspannungs-Primärseite (2),
b. eine Niederspannungs-Sekundärseite (3),
c. einen ohmsch-kapazitiven Spannungsteiler mit
i. einer ersten Widerstand-Kondensator-Parallelschaltung (4) und
ii. einer zweiten Widerstand-Kondensator-Parallelschaltung (4'),
d. wobei die Widerstand-Kondensator-Parallelschaltungen (4, 4') elektrisch in Serie angeordnet sind,
e. wobei der Spannungsabfall an der zweiten Widerstand-Kondensator-Parallelschaltung (4') in einer Relation zur Hochspannung steht,
**wobei**
zum elektrischen Abgleich der Sekundärseite (3) parallel zur zweiten Widerstand-Kondensator-Parallelschaltung (4') ein Widerstand-Kondensator-Netzwerk (5) mit einer Vielzahl an parallel geschalteten und selektiv deaktivierbaren Widerständen (6, 6', 6") und Kondensatoren (7, 7', 7") vorgesehen ist,
**dadurch gekennzeichnet, dass**
das Widerstands-Kondensator-Netzwerk (5) eine Vielzahl an parallelen Widerständen (6, 6', 6") umfasst, insbesondere bis zu 15 Widerstände (6, 6', 6"), wobei in Serie zu jedem Widerstand jeweils eine Schmelzsicherung (8, 8', 8") angeordnet ist.

2. Spannungssensor (1) nach Anspruch 1, **dadurch gekennzeichnet, dass** das Widerstands-Kondensator-Netzwerk (5) eine Vielzahl an parallelen Kondensatoren (7, 7', 7") umfasst, insbesondere bis zu 10 Kondensatoren (7, 7', 7"), wobei in Serie zu jedem Kondensator jeweils eine Schmelzsicherung (9, 9', 9") angeordnet ist.

3. Spannungssensor nach Anspruch 2, **dadurch gekennzeichnet, dass** die Schmelzsicherungen (8, 8', 8", 9, 9', 9") über separate elektrische Anschlussleitungen (10, 10', 10", 11, 11', 11") verfügen.

4. Spannungssensor nach Anspruch 3, **dadurch gekennzeichnet, dass** die Anschlussleitungen (10, 10', 10", 11, 11', 11") einzeln an ein elektrisches Steckpanel (12) geführt sind.

5. Spannungssensor nach Anspruch 4, **dadurch gekennzeichnet, dass** das Steckpanel (12) an einer Außenfläche des Spannungssensors (1) angeordnet ist.

6. Spannungssensor nach einem der Ansprüche 1 bis 5, **dadurch gekennzeichnet, dass** dieser zur Messung einer Hochspannung von über 1 kV, insbesondere über 20 kV ausgelegt ist.

7. Messanordnung, umfassend einen Spannungssensor (1) nach einem der Ansprüche 1 bis 6, wobei die Sekundärseite (3) über eine geschirmte Messleitung (13) mit einem Messverstärker (14) verbunden ist.

## Claims

1. A Voltage sensor (1) for measuring a high voltage, comprising
a. a high-voltage primary side (2),
b. a low-voltage secondary side (3),
c. an ohmic capacitive voltage divider having
i. a first resistor-capacitor parallel circuit (4) and
ii. a second resistor-capacitor parallel circuit (4'),
d. wherein the resistor-capacitor parallel circuits (4, 4') are electrically arranged in series,
e. wherein the voltage drop across the second resistor-capacitor parallel circuit (4') is correlated to the high voltage,
**wherein**
a resistor-capacitor network (5) with a plurality of resistors (6, 6', 6") and capacitors (7, 7', 7") connected in parallel and selectively deactivatable is provided for electrically balancing the secondary side (3) in parallel with the second resistor-capacitor parallel circuit (4'),
**characterised in that**
the resistor-capacitor network (5) comprises a plurality of parallel resistors (6, 6', 6"), in particular up to 15 resistors (6, 6', 6"), wherein a fuse (8, 8', 8") is arranged in series with each resistor.

2. The voltage sensor (1) according to claim 1, **characterised in that** the resistor-capacitor network (5) comprises a plurality of parallel capacitors (7, 7', 7"), in particular up to 10 capacitors (7, 7', 7"), wherein a fuse (9, 9', 9") is arranged in series with each capacitor.

3. The voltage sensor according to claim 2, **characterised in that** the fuses (8, 8', 8", 9, 9', 9") have separate electrical connection lines (10, 10', 10", 11, 11', 11").

4. The voltage sensor according to claim 3, **characterised in that** the connecting lines (10, 10', 10", 11, 11', 11") are routed individually to an electrical plug-in panel (12).

5. The voltage sensor according to claim 4, **characterised in that** the plug-in panel (12) is arranged on an outer surface of the voltage sensor (1).

6. The voltage sensor according to one of claims 1 to 5, **characterised in that** it is configured to measure a high voltage of over 1 kV, in particular over 20 kV.

7. A measuring arrangement comprising a voltage sensor (1) according to one of claims 1 to 6, wherein the secondary side (3) is connected to a measuring amplifier (14) via a shielded measuring line (13).

## Revendications

1. Capteur de tension (1) pour mesurer une haute tension, comprenant
a. un côté primaire haute tension (2),
b. un côté secondaire basse tension (3),
c. un diviseur de tension ohmique-capacitif avec
i. un premier circuit parallèle résistance-condensateur (4) et
ii. un deuxième circuit parallèle résistance-condensateur (4'),
d. dans lequel les circuits parallèles résistance-condensateur (4, 4') sont disposés électriquement en série,
e. dans lequel la chute de tension au niveau du deuxième circuit parallèle résistance-condensateur (4') est en relation avec la haute tension,
**dans lequel**
pour l'équilibrage électrique du côté secondaire (3), en parallèle avec le deuxième circuit parallèle résistance-condensateur (4'), un réseau résistance-condensateur (5) avec une pluralité de résistances (6, 6', 6") et de condensateurs (7, 7', 7") montés en parallèle et désactivables de manière sélective est prévu,
**caractérisé en ce que**
le réseau résistance-condensateur (5) comprend une pluralité de résistances parallèles (6, 6', 6"), en particulier jusqu'à 15 résistances (6, 6', 6"), dans lequel un fusible (8, 8', 8") est respectivement disposé en série avec chaque résistance.

2. Capteur de tension (1) selon la revendication 1, **caractérisé en ce que** le réseau résistance-condensateur (5) comprend une pluralité de condensateurs parallèles (7, 7', 7"), en particulier jusqu'à 10 condensateurs (7, 7', 7"), dans lequel un fusible (9, 9', 9") est respectivement disposé en série avec chaque condensateur.

3. Capteur de tension selon la revendication 2, **caractérisé en ce que** les fusibles (8, 8', 8", 9, 9', 9") disposent de lignes de raccordement électrique séparées (10, 10', 10", 11, 11', 11").

4. Capteur de tension selon la revendication 3, **caractérisé en ce que** les lignes de raccordement (10, 10', 10", 11, 11', 11") sont amenées individuellement à un panneau électrique enfichable (12).

5. Capteur de tension selon la revendication 4, **caractérisé en ce que** le panneau enfichable (12) est disposé sur une surface extérieure du capteur de tension (1).

6. Capteur de tension selon l'une des revendications 1 à 5, **caractérisé en ce qu'**il est conçu pour mesurer une haute tension supérieure à 1 kV, en particulier supérieure à 20 kV.

7. Agencement de mesure, comprenant un capteur de tension (1) selon l'une des revendications 1 à 6, dans lequel le côté secondaire (3) est relié à un amplificateur de mesure (14) par une ligne de mesure blindée (13).
